(19) Europäisches Patentamt

European Patent Office

Office européen des brevets

(11) **EP 1 475 895 A1**

(12) **DEMANDE DE BREVET EUROPEEN**

(43) Date de publication:
**10.11.2004 Bulletin 2004/46**

(51) Int Cl.[7]: **H03M 13/41**

(21) Numéro de dépôt: **04354020.2**

(22) Date de dépôt: **10.05.2004**

(84) Etats contractants désignés:
**AT BE BG CH CY CZ DE DK EE ES FI FR GB GR HU IE IT LI LU MC NL PL PT RO SE SI SK TR**
Etats d'extension désignés:
**AL HR LT LV MK**

(30) Priorité: **09.05.2003 FR 0305648**

(71) Demandeur: **ST MICROELECTRONICS S.A.**
**92120 Montrouge (FR)**

(72) Inventeurs:
• **Urard, Pascal**
**38570 Theys (FR)**
• **Paumier, Laurent**
**38000 Grenoble (FR)**
• **Lantreibecq, Etienne**
**73190 Challes les Eaux (FR)**

(74) Mandataire: **de Beaumont, Michel**
**Cabinet Michel de Beaumont**
**1, rue Champollion**
**38000 Grenoble (FR)**

(54) **Dispositif et procédé d'addition-comparaison-sélection-ajustement dans un décodeur**

(57) L'invention concerne un dispositif (MM1) d'addition-comparaison-sélection-ajustement comprenant :

des premier et deuxième additionneurs (10, 11) pour produire des valeurs a et b respectivement égales à la somme de premières métriques d'état précédent ($MI_1$) et de branche ($GI_1$) et à la somme de deuxièmes métriques d'état précédent ($MI_2$) et de branche ($GI_2$) ;
un bloc de calcul (12) pour fournir la plus grande des valeurs a et b sur une première sortie, et produire une valeur d'ajustement sur une deuxième sortie ; et
un troisième additionneur (19) pour produire une métrique d'état courant égale à la somme des sorties du bloc de calcul ;

dans lequel les additionneurs (10, 11, 19) effectuent des additions sans conservation de la retenue de telle manière que la métrique d'état courant et les valeurs intermédiaires a et b comportent le même nombre de bits que les premières et deuxième métriques d'état précédent ($MI_1$, $MI_2$).

Fig 3

Printed by Jouve, 75001 PARIS (FR)

EP 1 475 895 A1

## Description

La présente invention concerne de façon générale les décodeurs de signaux, comme par exemple les décodeurs du type turbodécodeurs. Plus particulièrement, la présente invention concerne des modules particuliers utilisés dans de tels décodeurs, appelés généralement modules ACSO ("Add-Compare-Select-Offset"-"Additionner-Comparer-Sélectionner-Ajuster") qui réalisent des opérations d'addition pour fournir une pluralité de données, puis de comparaison des données obtenues et de sélection d'une donnée parmi les données obtenues et d'ajustement de la donnée sélectionnée.

L'un des objectifs des communications numériques est la transmission de données sans erreur. Durant la transmission, les données sont soumises à du bruit qui peut causer des erreurs sur les données reçues. Pour améliorer la fiabilité lors de la transmission des données, on utilise des techniques de correction d'erreur. Une technique connue de correction d'erreur est le codage par convolution. Cette technique fournit une correction d'erreur efficace mais nécessite des techniques de décodage sophistiquées.

Les codes de correction d'erreur présentent un effet technique important puisqu'ils permettent la correction d'erreur de données transmises entre un émetteur et un récepteur dans des applications telles que les télécommunications.

Les codes de convolution permettent au récepteur de données numériques de déterminer correctement les données transmises même lorsque des erreurs se sont produites durant la transmission. Les codes de convolution introduisent des redondances dans les données à transmettre et fournissent les données transmises séquentiellement dans des paquets dans lesquels la valeur de chaque bit est dépendante de bits précédents dans la séquence. Ainsi, lorsque des erreurs se produisent, le récepteur peut déduire les données d'origine en retraçant les séquences possibles de données reçues.

Pour améliorer l'efficacité du codage, des procédés de codage comprennent des brasseurs, qui mélangent l'ordre des bits du paquet codé. Ainsi, lorsque des bits adjacents sont altérés durant la transmission, l'erreur est répartie sur la totalité du paquet initial et peut être ainsi plus efficacement corrigée.

D'autres améliorations peuvent comprendre des codeurs qui codent les données à transmettre plus d'une fois, en parallèle ou en série. Par exemple, on connaît des procédés de correction d'erreur qui transmettent des paquets de données codées pour lesquels chaque paquet est formé par la juxtaposition de données initiales non codées, de premières données codées issues d'un codage des données initiales par un premier codeur, et de deuxièmes données codées issues d'un codage des données initiales par un second codeur précédé d'un brasseur. Un tel procédé de correction d'erreur est appelé codage convolutif parallèle systématique (CCPS). Chaque paquet de données transmis peut correspondre à un seul bit des données initiales, on parle alors de codage en mode monobinaire ; ou correspondre à un couple de bits (ou "bibit") des données initiales, on parle alors de codage en mode duobinaire.

On sait décoder par "turbodécodage" des données codées en mode monobinaire avec un algorithme itératif, relativement efficace pour atteindre des taux d'erreur peu élevés. Plutôt que de déterminer immédiatement si les données reçues sont égales à "0" ou à "1", le récepteur attribue à chaque donnée reçue une valeur sur une échelle à plusieurs niveaux représentant la probabilité que la donnée soit égale à "1". Une échelle classique, que l'on appelle de façon habituelle rapport de probabilité logarithmique ("log likelihood ratio") LLR, représente chaque donnée décodée x par un entier codé sur un nombre prédéterminé de bits. Pour une donnée reçue r, le rapport LLR est déterminé de la façon suivante :

$$LLR(x) = \log\left(\frac{\Pr(x = 1/r)}{\Pr(x = 0/r)}\right) \qquad (1)$$

où Pr(x=1/r) représente la probabilité que la donnée décodée x soit égale à "1" pour la donnée r reçue et Pr(x=0/r) représente la probabilité que la donnée décodée x soit égale à "0" pour la donnée r reçue.

Le procédé de décodage itératif reçoit une séquence d'entrée correspondant à des probabilités pour chaque valeur reçue et fournit en sortie des probabilités corrigées. Le décodage itératif est réalisé par plusieurs itérations après lesquelles la probabilité corrigée représente la donnée transmise de façon suffisamment proche.

On compare alors la valeur du rapport LLR à un seuil pour déterminer la valeur de la donnée décodée x. Par exemple, la donnée décodée est prise égale à "1" lorsque le rapport LLR est positif, et à "0" autrement. Le rapport LLR contient donc à la fois une information représentative de la valeur de la donnée décodée x et une information représentative de la fiabilité de la valeur de la donnée décodée.

L'algorithme de calcul du rapport LLR est basé sur un treillis similaire à celui utilisé dans l'algorithme de Viterbi.

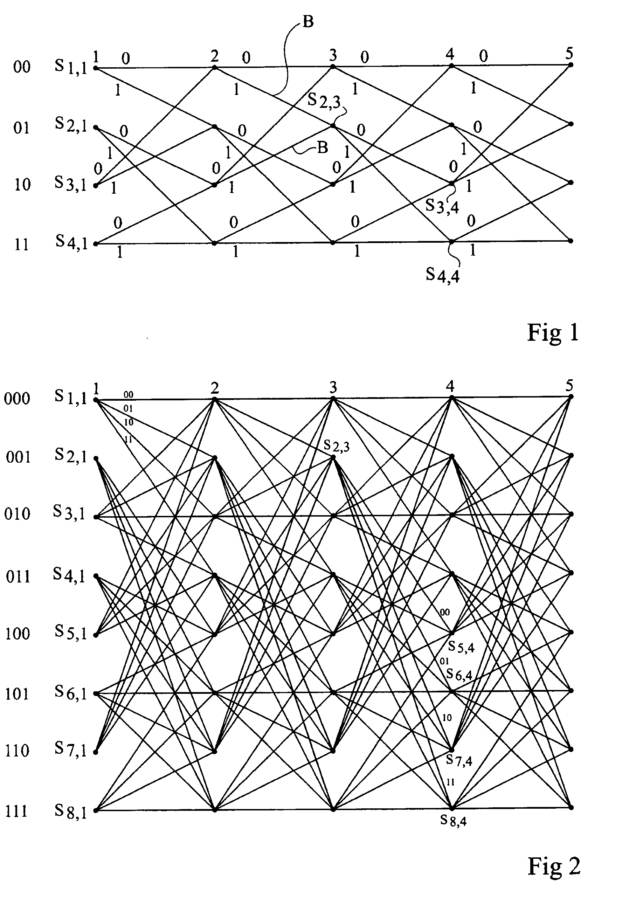

La figure 1 représente un exemple de treillis à N états, N étant égal à 4 en figure 1. Quatre états $S_i$, i allant

de 1 à 4, sont représentés selon la direction verticale. Différents instants k, k allant de 1 à 5, sont représentés selon la direction horizontale. Chaque point $S_{i,k}$ du treillis représente le i$^{ème}$ état à l'instant k. Un état peut représenter une séquence d'un nombre déterminé de bits correspondant à l'état supposé de plusieurs bascules du codeur convolutif à la transmission. Pour un treillis à quatre états, chaque état peut être associé à l'une des séquences ("00", "01", "10", "11") correspondant à l'état supposé de deux bascules du codeur. Une branche B représente une transition entre un état à un instant k et un état à un instant k+1. La transition d'un état vers un autre correspond à la réception par le décodeur d'une donnée correspondant à un bit de valeur "0" ou "1". A partir d'un état à un instant k, par exemple l'état $S_{2,3}$, il n'y a donc que deux transitions possibles vers les états $S_{3,4}$ et $S_{4,4}$ selon que la donnée reçue est un bit de valeur "0" ou "1".

En pratique, la donnée $r_k$ reçue à un instant k est une donnée analogique. On détermine pour une branche du treillis reliant l'état $S_{i,k}$ et l'état $S_{m,k+1}$ une métrique $\gamma_k$ de la branche correspondant à une transition possible de l'état $S_{i,k}$ vers l'état $S_{m,k+1}$. La métrique de branche correspond à une distance entre la donnée reçue $r_k$ et la donnée $x_k(S_{i,k}, S_{m,k+1})$ qu'on aurait dû recevoir pour la branche. Elle peut être calculée de la façon suivante :

$$\gamma_k(S_{i,k}, S_{m,k+1}) = \exp\left[ -\frac{1}{2\sigma^2}\left\| r_k - x_k(S_{i,k}, S_{m,k+1}) \right\|^2 \right] \qquad (2)$$

où $\sigma^2$ est la variance de bruit associée à la donnée reçue $r_k$ et $\gamma_k(S_{i,k}, S_{m,k+1})=0$ s'il n'existe aucune branche entre les états $S_{i,k}$ et $S_{m,k}$. On distingue par la suite deux catégories de métriques de branche :

$\gamma_k^1(S_{i,k}, S_{m,k+1})$, égale à $\gamma_k(S_{i,k}, S_{m,k+1})$ si la transition de l'état $S_{i,k}$ à l'état $S_{m,k+1}$ correspond à un bit d'information en entrée du codeur égal à 1, et égale à 0 sinon ; et

$\gamma_k^0(S_{i,k}, S_{m,k+1})$, égale à $\gamma_k(S_{i,k}, S_{m,k+1})$ si la transition de l'état $S_{i,k}$ à l'état $S_{m,k+1}$ correspond à un bit d'information en entrée du codeur égal à 0, et égale à 1 sinon.

L'algorithme de calcul du rapport LLR comporte trois étapes principales.

A un instant k, on calcule pour chaque état $S_{i,k}$, i allant de 1 à N, une probabilité amont $\alpha_k(S_{i,k})$ de se trouver à l'état $S_{i,k}$ de la façon suivante :

$$\alpha_k(S_{i,k}) = \sum_{\ell=1}^{N} \sum_{j=0}^{1} \alpha_{k-1}(S_{\ell,k-1})\gamma_k^j(S_{\ell,k-1}, S_{i,k}) \qquad (3)$$

On calcule également à l'instant k, pour chaque état $S_{i,k}$, i allant de 1 à N, une probabilité aval $\beta_k(S_{i,k})$ de se trouver à l'état $S_{i,k}$ par l'équation suivante :

$$\beta_k(S_{i,k}) = \sum_{\ell=1}^{N} \sum_{j=0}^{1} \beta_{k+1}(S_{\ell,k+1})\gamma_{k+1}^j(S_{i,k}, S_{\ell,k+1}) \qquad (4)$$

A partir de ces deux probabilités, on calcule le rapport LLR de la facon suivante :

$$LLR(x_k) = \log \frac{\displaystyle\sum_{(i,\ell)\in B(k,1)} \alpha_{k-1}(S_{\ell,k-1})\gamma_k^1(S_{\ell,k-1}, S_{i,k})\beta_k(S_{i,k})}{\displaystyle\sum_{(i,\ell)\in B(k,0)} \alpha_{k-1}(S_{\ell,k-1})\gamma_k^0(S_{\ell,k-1}, S_{i,k})\beta_k(S_{i,k})} \qquad (5)$$

où B(k,0) (respectivement B(k,1)) est l'ensemble des transitions possibles d'un état $S_{l,k-1}$ vers un état $S_{i,k}$ provoquées par une donnée d'entrée égale à "0" (respectivement "1").

Le calcul du rapport LLR nécessite le calcul de multiplications et de valeurs exponentielles. Ces opérations sont difficiles à mettre en oeuvre. Pour ce faire, on introduit la fonction suivante :

$$MAX^+(x,y)=\ln(e^x+e^y)=MAX(x,y)+\ln(1+e^{-|x-y|}) \tag{6}$$

où le terme $\ln(1+e^{-|x-y|})$ est une valeur d'ajustement. La valeur d'ajustement peut être obtenue au moyen d'une mémoire, par exemple une mémoire ROM, dans laquelle sont mémorisées des valeurs de la fonction $\ln(1+e^{-|v|})$ sur un nombre de bits déterminé pour certaines valeurs $|v|$ codées sur un nombre de bits déterminé. Il vient :

$$\ln(\sum_{i=0}^{N}e^{x_i}) = MAX^+\left(\ln(\sum_{i=0}^{N-1}e^{x_i}),x_i\right) \tag{7}$$

$$= MAX^+\left(MAX^+\left(\ln(\sum_{i=0}^{N-2}e^{x_i}),x_{N-1}\right),x_N\right) = ... = \underset{i\in[1,N]}{MAX^+}(x_i)$$

On introduit ainsi les définitions suivantes :

$$\bar{\gamma}_k^1(S_{m,n},S_{i,k}) = \log(\gamma_k^1(S_{m,n},S_{i,k}))$$

$$\bar{\gamma}_k^0(S_{m,n},S_{i,k}) = \log(\gamma_k^0(S_{m,n},S_{i,k})) \tag{8}$$

$$\bar{\alpha}_k(S_{i,k}) = \log\alpha_k(S_{i,k}) \tag{9}$$

Le terme $\bar{\alpha}_k(S_{i,k})$ est appelé métrique amont d'état ("forward state metrics") pour l'état $S_{i,k}$ ou métrique amont de chemin pour l'état $S_{i,k}$.

$$\bar{\beta}_k(S_{i,k}) = \log(\beta_k(S_{i,k})) \tag{10}$$

Le terme $\bar{\beta}_k(S_{i,k})$ est appelé métrique aval d'état ("backward state metrics") pour l'état $S_{i,k}$ ou métrique aval de chemin pour l'état $S_{i,k}$.
Il en résulte que :

$$\bar{\alpha}_k(S_{i,k}) = \underset{(i,m)\in B(k,j)}{MAX^+}(\bar{\alpha}_{k-1}(S_{m,k-1}) + \bar{\gamma}_k^j(S_{m,k-1},S_{i,k})) \tag{11}$$

$$\bar{\beta}_{k-1}(S_{i,k-1}) = \underset{(m,i)\in B(k,j)}{MAX}{}^+(\bar{\beta}_k(S_{m,k}) + \bar{\gamma}_k^j(S_{i,k-1},S_{m,k})) \tag{12}$$

L'expression du rapport LLR devient :

$$LLR(x_k) = \underset{(i,m)\in B(k,1)}{MAX}{}^{+}(\bar\alpha_{k-1}(S_{m,k-1}) + \bar\gamma_k^{-1}(S_{m,k-1},S_{i,k}) + \bar\beta_k(S_{i,k}))$$

$$- \underset{(i,m)\in B(k,0)}{MAX}{}^{+}(\bar\alpha_{k-1}(S_{m,k-1}) + \bar\gamma_k^{-0}(S_{m,k-1},S_{i,k}) + \bar\beta_k(S_{i,k})) \qquad (13)$$

Les calculs des métriques amont $\bar\alpha k(S_{i,k})$ et aval $\bar\beta k(S_{i,k})$ d'état sont réalisés par des modules particuliers du décodeur appelés modules ACSO ("ADD-COMPARE-SELECT-OFFSET"-"Additionner-Comparer-Sélectionner-Ajuster") qui mettent en oeuvre la fonction MAX⁺.

Le fonctionnement itératif d'un module ACSO implique de réaliser plusieurs accumulations d'un grand nombre de sommes de métriques d'état et de branche en une durée inférieure à la période séparant la réception de deux bits successifs. Une telle vitesse de fonctionnement implique généralement d'utiliser des moyens redondants dans les modules ACSO, ce qui rend complexe la structure de ces modules. De plus, afin de limiter la taille des additionneurs utilisés pour les accumulations sans risquer une perte d'information due à une saturation des additionneurs, les modules ACSO comportent des moyens de limitation pour, par exemple lorsque l'une des accumulations dépasse un seuil prédéterminé, diviser toutes les accumulations par une valeur prédéterminée. De tels moyens de limitation des accumulations rendent également la structure des modules ACSO complexe. Les modules ACSO peuvent comporter également des moyens permettant de compenser une variation des métriques de branche due à une variation de gain de transmission. De tels moyens de compensation du gain ont en particulier pour effet d'accroître la taille de la mémoire ROM dans laquelle sont mémorisées les valeurs d'ajustement, et rendent plus complexes encore les moyens précédents de limitation des accumulations.

Un codage en mode duobinaire permet de transmettre à fréquence égale les données avec un débit plus élevé qu'un codage en mode monobinaire. On ne connaît cependant actuellement pas de dispositifs simples pour mettre en oeuvre un décodage en mode duobinaire.

Un objet de l'invention consiste à prévoir un dispositif simple et peu coûteux pour mettre en oeuvre un décodage en mode monobinaire.

Un autre objet de l'invention consiste à prévoir un dispositif simple et peu coûteux pour mettre en oeuvre un décodage en mode duobinaire.

Pour atteindre ces objets, ainsi que d'autres, la présente invention prévoit un dispositif pour réaliser une fonction de type addition-comparaison-sélection-ajustement dans un décodeur de codes de correction d'erreur, comprenant :

des premier et deuxième additionneurs pour produire des première et deuxième valeurs intermédiaires de métrique a et b respectivement égales à la somme d'une première métrique d'état précédent et d'une métrique de branche associée et à la somme d'une deuxième métrique d'état précédent et d'une métrique de branche associée ;
un bloc de calcul recevant les valeurs a et b, pour comparer les valeurs a et b, sélectionner la plus grande des valeurs a et b et fournir ladite valeur sélectionnée sur une première sortie, et pour produire sur une deuxième sortie une valeur d'ajustement correspondant à une approximation de $\ln(1+e^{-|a-b|})$ ; et
un troisième additionneur pour produire une métrique d'état courant égale à la somme des sorties du bloc de calcul ;

dans lequel les première et deuxième métriques d'état précédent sont codées sur un même nombre de bits, et dans lequel les additionneurs effectuent des additions sans conservation de la retenue de telle manière que la métrique d'état courant et les valeurs intermédiaires a et b comportent le même nombre de bits que les première et deuxième métriques d'état précédent.

La présente invention vise également un dispositif pour réaliser une fonction de type addition-comparaison-sélection-ajustement dans un décodeur de codes de correction d'erreur fonctionnant en mode duobinaire, comprenant :

des premier et second dispositifs tels que décrits précédemment comprenant respectivement des premier et deuxième blocs de calcul pour produire des première et deuxième métriques d'état courant respectivement à partir de première et deuxième métriques d'état précédent et de première et deuxième métriques de branches associées et à partir de troisième et quatrième métriques d'état précédent et de troisième et quatrième métriques de branche associées ;
un troisième bloc de calcul tel que décrit précédemment recevant en entrée les première et deuxième métriques d'état courant ; et

un additionneur pour produire une troisième métrique d'état courant égale à la somme des sorties du troisième bloc de calcul, dans lequel les métriques d'état précédent sont codées chacune sur un même nombre de bits, ledit additionneur effectuant des additions sans conservation de la retenue de telle manière que la troisième métrique d'état courant comporte le même nombre de bits que les métriques d'état précédent.

Selon un mode de réalisation de l'invention, le bloc de calcul comporte un soustracteur pour calculer la différence des première et deuxième valeurs reçues par le bloc de calcul, un multiplexeur commandé par la sortie du soustracteur pour produire sur la première sortie du bloc de calcul la plus grande des valeurs reçues, et un bloc d'approximation pour produire sur la deuxième sortie du bloc de calcul la valeur d'ajustement sous la forme d'une valeur de un bit égale à 1 si ladite différence est égale à 0, 1 ou -1 et égale à 0 sinon.

Selon un mode de réalisation de l'invention, le bloc d'approximation comporte une première porte logique calculant un NON-OU de tous les bits de ladite différence à l'exception de son bit de poids le plus faible, une deuxième porte logique calculant un ET de tous les bits de ladite différence, et une troisième porte logique calculant un OU des sorties des première et deuxième portes logiques.

La présente invention vise également un décodeur comportant $2^N$, où N est supérieur à 1, dispositifs en mode duobinaire tel que décrit précédemment, dont chacun est associé à une valeur de N bits particulière, le décodeur recevant des données sous forme de bibits consécutifs ;

la sortie de chaque dispositif associé à une première valeur étant connectée de manière à fournir l'une des métriques d'état précédent à quatre dispositifs, associés chacun à une valeur dont les N-2 bits de poids fort sont les N-2 bits de poids faible de ladite première valeur et dont les deux bits de poids faibles sont respectivement l'une des quatre valeurs possibles du dernier bibit reçu ;

chaque dispositif associé à une première valeur dont les deux bits de poids faible sont l'une des quatre valeurs possibles (00, 01, 10, 11) d'un bibit recevant comme métriques de branche une valeur correspondant à une distance entre le bibit reçu et ladite une des quatre valeurs possibles d'un bibit.

La présente invention vise également un procédé pour réaliser une fonction de type addition-comparaison-sélection-ajustement dans un décodeur de codes de correction d'erreur fonctionnant en mode monobinaire, comprenant les étapes suivantes :

i/ produire des première et deuxième valeurs intermédiaires de métrique, a et b, respectivement égales à la somme d'une première métrique d'état précédent et d'une métrique de branche associée et à la somme d'une deuxième métrique d'état précédent et d'une métrique de branche associée ;

ii/ comparer les valeurs a et b, sélectionner la plus grande des valeurs a et b et fournir ladite valeur sélectionnée sur une première sortie, et produire sur une deuxième sortie une valeur d'ajustement correspondant à une approximation de $\ln(1+e^{-|a-b|})$ ; et

iii/ produire une métrique d'état courant égale à la somme des sorties du bloc de calcul ;

les première et deuxième métriques d'état précédent étant codées sur un même nombre de bits et les sommes calculées aux étapes i/ et iii/ étant réalisées sans conservation de la retenue, de telle manière que la métrique d'état courant et les valeurs intermédiaires a et b comportent le même nombre de bits que les première et deuxième métriques d'état précédent.

La présente invention vise également un procédé pour réaliser une fonction de type addition-comparaison-sélection-ajustement dans un décodeur de codes de correction d'erreur fonctionnant en mode duobinaire, comprenant les étapes suivantes :

iv/ produire des première et deuxième métriques d'état courant selon le procédé en mode monobinaire décrit précédemment, respectivement à partir de première et deuxième métriques d'état précédent et de première et deuxième métriques de branches associées et à partir de troisième et quatrième métriques d'état précédent et de troisième et quatrième métriques de branches associées ;

v/ fournir une valeur sélectionnée et une valeur d'approximation calculées selon l'étape ii/ du procédé en mode monobinaire décrit précédemment, à partir des première et deuxième métriques d'état courant ; et

vi/ produire une troisième métrique d'état courant égale à la somme des valeurs produites à l'étape v/, les métriques d'état précédent étant codées chacune sur un même nombre de bits et ladite somme étant effectuée sans conservation de la retenue de telle manière que la troisième métrique d'état courant comporte le même nombre de bits que les métriques d'état précédent.

Selon un mode de réalisation de l'invention, à l'étape ii/, la valeur est sélectionnée en calculant la différence des valeurs comparées et en fournissant la plus grande des valeurs comparées sur la base du signe de ladite différence, et la valeur d'ajustement est produite comme étant une valeur de un bit égale à 1 si ladite différence est égale à 0, 1 ou -1 et égale à 0 sinon.

Selon un mode de réalisation de l'invention, la valeur d'ajustement est égale au OU logique d'un NON-OU logique de tous les bits de ladite différence à l'exception de son bit de poids le plus faible et d'un ET logique de tous les bits de ladite différence.

La présente invention vise également un procédé de décodage selon un treillis comportant $2^N$, où N est supérieur à 1, états associés chacun à une valeur de N bits particulière, de données reçues sous la forme de bibits consécutifs, comportant les étapes suivantes :

vii/ pour le premier bibit reçu, produire selon le procédé de décodage en mode duobinaire décrit précédemment $2^N$ métriques d'état courant associées chacune à l'une desdites valeurs à partir de quatre métriques d'état précédent initiales prédéterminées et à partir de quatre métriques de branche identiques correspondant à une distance entre le bibit reçu et une valeur du bibit égale aux deux bits de poids faible de ladite une desdites valeurs ;

viii/ pour chaque bibit reçu ultérieurement, produire selon le procédé de décodage en mode duobinaire décrit précédemment $2^N$ métriques d'état courant associées chacune à l'une desdites valeurs en prenant pour les quatre métriques d'état précédent les quatre métriques d'état courant produites pour le bibit reçu précédent et associées à une valeur dont les N-2 bits de poids faible sont les N-2 bits de poids fort de ladite une desdites valeurs, et en prenant pour les quatre métriques de branche une distance entre le bibit reçu et une valeur du bibit égale aux deux bits de poids faible de ladite une desdites valeurs.

Ces objets, caractéristiques et avantages, ainsi que d'autres de la présente invention seront exposés en détail dans la description suivante de modes de réalisation particuliers faite à titre non limitatif en relation avec les figures jointes parmi lesquelles :

la figure 1, précédemment décrite, représente un exemple de treillis utilisé pour un décodage monobinaire ;

la figure 2 représente un exemple de treillis utilisé pour un décodage duobinaire selon la présente invention ;

la figure 3 représente un mode de réalisation d'un module ACSO selon la présente invention ; et

la figure 4 représente un exemple de circuit de décodage correspondant au treillis de la figure 2 utilisant des modules ACSO tels qu'en figure 3.

La figure 2 représente un exemple de treillis de décodage de données codées en mode duobinaire. Le treillis comporte 5 colonnes comportant chacune 8 états $S_{i,j}$ où i = 1-8 et j = 1-5. Chaque colonne est associée à un instant différent correspondant à la réception d'un nouveau bibit de données. Pour un treillis à huit états, chaque état peut être associé à l'une des séquences ("000", "001", "010", "011", "100", "101", "110", "111") des états internes du codeur convolutif. A partir de chaque état à un instant k (par exemple l'état $S_{2,3}$) il y a quatre transitions possibles (dans l'exemple considéré vers les états $S_{5,4}$, $S_{6,4}$, $S_{7,4}$ et $S_{8,4}$, selon que le bibit reçu a une valeur "00", "01", "10" ou "11").

En pratique, comme pour un décodage en mode monobinaire, un bibit transmis est reçu à chaque instant k sous la forme d'une donnée analogique, et on associe à chaque branche du treillis une métrique de branche $\gamma_k$ calculée sensiblement de la même manière que selon l'équation (2) précédente, si l'on appelle $r_k$ la valeur analogique reçue et $x_k$ le bibit que l'on aurait dû recevoir pour la branche, ou "bibit reçu".

On distingue par la suite quatre catégories de métriques de branche :

$\gamma_k^{00}(S_{i,k}, S_{m,k+1})$, égale à $\gamma_k(S_{i,k}, S_{m,k+1})$ si la transition de l'état $S_{i,k}$ à l'état $S_{m,k+1}$ correspond à un bibit d'information en entrée du codeur égal à 00, et égale à 0 sinon ;

$\gamma_k^{01}(S_{i,k}, S_{m,k+1})$, égale à $\gamma_k(S_{i,k}, S_{m,k+1})$ si la transition de l'état $S_{i,k}$ à l'état $S_{m,k+1}$ correspond à un bibit d'information en entrée du codeur égal à 01, et égale à 1 sinon ;

$\gamma_k^{10}(S_{i,k}, S_{m,k+1})$, égale à $\gamma_k(S_{i,k}, S_{m,k+1})$ si la transition de l'état $S_{i,k}$ à l'état $S_{m,k+1}$ correspond à un bibit d'information en entrée du codeur égal à 10, et égale à 0 sinon ;

$\gamma_k^{11}(S_{i,k}, S_{m,k+1})$, égale à $\gamma_k(S_{i,k}, S_{m,k+1})$ si la transition de l'état $S_{i,k}$ à l'état $S_{m,k+1}$ correspond à un bibit d'information en entrée du codeur égal à 11, et égale à 1 sinon.

Les inventeurs ont montré que l'on peut, par exemple en suivant un treillis tel qu'en figure 2, mesurer à chaque instant la probabilité pour que le bibit reçu ait l'une des quatre valeurs possibles au moyen de quatre rapports LLR calculés chacun de la façon suivante :

$$LLR_{00}(x_k) = \underset{(i,m)\in B(k,00)}{MAX}^+ (\bar{\alpha}_{k-1}(S_{m,k-1}) + \bar{\gamma}_k^{00}(S_{m,k-1},S_{i,k}) + \bar{\beta}_k(S_{i,k}))$$

$$LLR_{01}(x_k) = \underset{(i,m)\in B(k,01)}{MAX}^+ (\bar{\alpha}_{k-1}(S_{m,k-1}) + \bar{\gamma}_k^{01}(S_{m,k-1},S_{i,k}) + \bar{\beta}_k(S_{i,k}))$$

$$LLR_{10}(x_k) = \underset{(i,m)\in B(k,10)}{MAX}^+ (\bar{\alpha}_{k-1}(S_{m,k-1}) + \bar{\gamma}_k^{10}(S_{m,k-1},S_{i,k}) + \bar{\beta}_k(S_{i,k}))$$

$$LLR_{11}(x_k) = \underset{(i,m)\in B(k,11)}{MAX}^+ (\bar{\alpha}_{k-1}(S_{m,k-1}) + \bar{\gamma}_k^{11}(S_{m,k-1},S_{i,k}) + \bar{\beta}_k(S_{i,k})) \qquad (14)$$

où $B(k,00)$, (respectivement $B(k,01)$, $B(k,10)$, $B(k,11)$) est l'ensemble des transitions possibles d'un état $S_{m,k-1}$ vers un état $S_{i,k}$ provoquées par un bibit d'entrée égal à "00" (respectivement "01", "10", "11"). Le décodage s'effectue en comparant les LLR calculés :

si MAX($LLR_{00}(x_k)$, $LLR_{01}(x_k)$, $LLR_{10}(x_k)$, $LLR_{11}(x_k)$) = $LLR_{00}(x_k)$, le bibit décodé est 00 ;
si MAX($LLR_{00}(x_k)$, $LLR_{01}(x_k)$, $LLR_{10}(x_k)$, $LLR_{11}(x_k)$) = $LLR_{01}(x_k)$, le bibit décodé est 01 ;
si MAX($LLR_{00}(x_k)$, $LLR_{01}(x_k)$, $LLR_{10}(x_k)$, $LLR_{11}(x_k)$) = $LLR_{10}(x_k)$, le bibit décodé est 10 ;
si MAX($LLR_{00}(x_k)$, $LLR_{01}(x_k)$, $LLR_{10}(x_k)$, $LLR_{11}(x_k)$) = $LLR_{11}(x_k)$, le bibit décodé est 11.

Les valeurs $\bar{\alpha}_{k-1}$, $\bar{\beta}_k$ sont respectivement calculées selon les équations (9) et (10) précédentes, avec $\alpha_k(S_{i,k})$ la probabilité amont de se trouver à l'état $S_{i,k}$, égale à :

$$\alpha_k(S_{i,k}) = \sum_{\ell=1}^{N} \sum_{j=00,01,10,11}^{3} \alpha_{k-1}(S_{\ell,k-1})\gamma_k^j(S_{\ell,k-1},S_{i,k}) \qquad (15)$$

et $\beta_k(S_{i,k})$, la probabilité aval de se trouver à l'état $S_{i,k}$, égale à :

$$\beta_k(S_{i,k}) = \sum_{\ell=1}^{N} \sum_{j=00,01,10,11}^{3} \beta_{k+1}(S_{\ell,k+1})\gamma_{k+1}^j(S_{i,k},S_{\ell,k+1}) \qquad (16)$$

Les inventeurs ont en particulier montré que :

$$\bar{\alpha}_k(S_{i,k}) = MAX^+(MAX^+(\bar{\alpha}_{k-1}(S_{m1,k-1}) + \bar{\gamma}_k^{00}(S_{m1,k-1},S_{i,k})),$$

$$(\bar{\alpha}_{k-1}(S_{m2,k-1}) + \bar{\gamma}_k^{01}(S_{m2,k-1},S_{i,k})),$$

$$MAX^+(\bar{\alpha}_{k-1}(S_{m3,k-1}) + \bar{\gamma}_k^{10}(S_{m3,k-1},S_{i,k})),$$

$$(\bar{\alpha}_{k-1}(S_{m4,k-1}) + \bar{\gamma}_k^{11}(S_{m4,k-1}S_{i,k})) \; (17) \qquad\qquad (17)$$

Et que :

$$\bar{\beta}_{k-1}(S_{i,k-1}) = MAX^+(MAX^+(\bar{\beta}_k(S_{m1,k}) + \bar{\gamma}_k^{00}(S_{i,k-1},S_{m1,k})),$$

$$(\bar{\beta}_k(S_{m2,k}) + \bar{\gamma}_k^{01}(S_{i,k-1},S_{m2,k})),$$

$$MAX^+(\bar{\beta}_k(S_{m3,k}) + \bar{\gamma}_k^{10}(S_{i,k-1},S_{m3,k})),$$

$$(\bar{\beta}_k(S_{m4,k}) + \bar{\gamma}_k^{-11}(S_{i,k-1}, S_{m4,k})) \tag{18}$$

Avec Sm1, Sm2, Sm3, Sm4 les états précédant l'état Si (dans le cas du calcul de $\alpha$, et suivant l'état Si dans le cas du calcul de $\beta$) pour des transitions dues respectivement aux bibits 00, 01, 10 et 11 en entrée.

Il découle des formules (17) et (18) précédentes que chacune des métriques d'état amont $\bar{\alpha}_k(S_{i,k})$ et aval $\bar{\beta}_k(S_{i,k})$ peut être calculée par un module ACSO en mode duobinaire selon l'invention, comportant deux modules ACSO en mode monobinaire calculant chacun le MAX$^+$ de deux sommes d'une métrique d'état et d'une métrique de branche associée, suivis d'un bloc calculant le MAX$^+$ des résultats des modules ACSO en mode monobinaire.

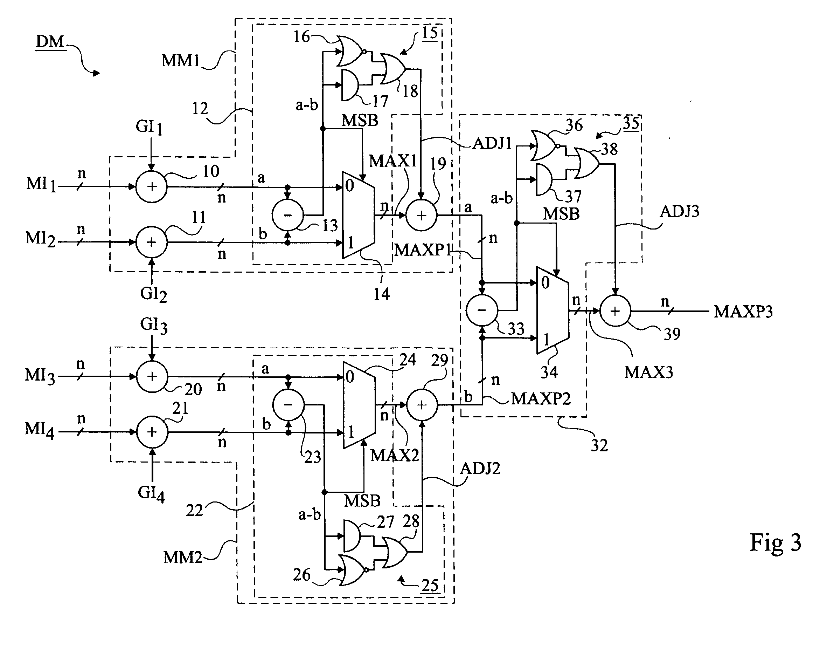

La figure 3 représente un module ACSO en mode duobinaire MM1 selon l'invention, permettant le calcul de la métrique d'état (amont ou aval) d'un état considéré à un instant donné k. Par la suite, on utilise le terme métrique d'état indifféremment pour une métrique d'état amont ou une métrique d'état aval et, lorsqu'on fait référence à un état adjacent à l'état considéré, cela signifie un état à un instant ultérieur k+1 ou antérieur k-1 à l'état considéré, suivant la métrique considérée.

Le module ACSO en mode duobinaire DM comporte un premier module ACSO en mode monobinaire MM1. Le module MM1 reçoit en entrée des données $MI_1$, $MI_2$ qui représentent respectivement des première et deuxième métriques d'état précédent. Le module MM1 reçoit également des données $GI_1$, $GI_2$ qui représentent des métriques de branche correspondant aux branches entre l'état considéré et respectivement les premier et deuxième états adjacents. Le module MM1 comporte deux additionneurs 10 et 11 recevant respectivement en entrée les données $MI_1$, $GI_1$ et $MI_2$, $GI_2$. Un bloc de calcul 12 reçoit sur deux entrées les valeurs (a, b) produites en sortie des additionneurs 10 et 11. Le bloc de calcul 12 comporte un soustracteur 13 calculant la différence a-b. Un multiplexeur 14 recevant les valeurs a et b fournit MAX1 = MAX(a,b), c'est-à-dire soit la valeur a soit la valeur b selon que la différence a-b est positive ou négative (selon que le bit de signe de a-b est égal à 0 ou 1). Un bloc 15 d'approximation reçoit la différence a-b et fournit une valeur ADJ1 égale à 1 si la différence a-b a une valeur égale à 0, 1 ou -1, et une valeur égale à 0 sinon. On montre que la valeur ADJ1 est une approximation codée sur 1 bit de la valeur d'ajustement $\ln(1+e^{-|a-b|})$. Le bloc 15 comporte par exemple une porte logique 16 calculant un NON-OU de tous les bits de la différence a-b à l'exception de son bit de poids le plus faible, une porte logique 17 calculant un ET de tous les bits de la différence a-b, et une porte logique 18 calculant un OU des sorties des portes 16 et 17. Un additionneur 19 fournit la somme MAXP1 des valeurs MAX1 et ADJ1, où MAXP1 = MAX$^+$(a,b) conformément à la formule (6).

Le module ACSO duobinaire DM comporte un deuxième module ACSO monobinaire MM2 de même structure que le module MM1, produisant une métrique d'état courant MAXP2 à partir de données $MI_3$, $MI_4$, $GI_3$ et $GI_4$ représentant respectivement des troisième et quatrièmes métriques d'état précédent et des métriques de branche correspondantes. De même références dans lesquelles le 1 des dizaines a été remplacé par un 2 désignent de mêmes éléments dans les modules MM1 et MM2.

Le module ACSO duobinaire DM comporte également un bloc de calcul 32 de même structure que le bloc de calcul 12 du module MM1. De même références dans lesquelles le 1 des dizaines a été remplacé par un 3 désignent de mêmes éléments dans les blocs 12 et 32. Le bloc 32 reçoit les sorties MAXP1 et MAXP2 des modules MM1 et MM2 et fournit à un additionneur 39 une valeur MAX3 égale au maximum de MAXP1 et MAXP2 et une valeur d'ajustement ADJ3 correspondant à $\ln(1+e^{-|MAXP1-MAXP2|})$. La sortie MAXP3 de l'additionneur 39 constitue la sortie du module DM. Le module DM fonctionne de préférence de manière synchrone, et comporte des moyens non représentés de synchronisation des données tels que des bascules D. Le module DM comporte également de préférence des moyens d'initialisation non représentés permettant par exemple de mettre à 0 de manière commandable les sorties des additionneurs 10 et 11 du module MM1 et des additionneurs correspondants du module MM2.

Les inventeurs ont mis en évidence que les performances d'un décodeur utilisant un module ACSO monobinaire selon l'invention tel que le module MM1, avec une valeur d'ajustement ADJ1 à un seul bit, ne sont pas dégradées par rapport aux performances d'un décodeur utilisant un module ACSO monobinaire classique avec une valeur d'ajustement à plusieurs bits stockée dans une ROM. En effet, un décodeur comporte d'autres systèmes (notamment en amont du calcul des LLR) dont le fonctionnement est davantage pénalisant pour les performances du décodeur, de sorte que l'utilisation d'une valeur d'ajustement à un seul bit n'a pas d'influence sur les performances globales du décodeur. On montre également qu'un décodeur utilisant un module DM avec des valeurs d'ajustement à un bit ADJ1, ADJ2 et ADJ3 selon l'invention ne présente pas de performances dégradées par rapport à un décodeur utilisant un module DM avec des valeurs d'ajustement à plusieurs bits produites au moyen de mémoires ROM, tout en ayant une taille sensiblement réduite par la suppression des mémoires ROM.

Les valeurs de métriques d'état $MI_1$, $MI_2$ sont codées sur un même nombre de bits n. Selon l'invention et de manière particulièrement avantageuse, les additionneurs 10, 11 et 19 du module MM1, fonctionnent modulo n sans conservation de la retenue, de manière à fournir chacun une sortie codée sur le même nombre de bits n. Les inventeurs ont en effet constaté que, lors de la mise en oeuvre des formules (17) ou (18) précédentes, la différence maximale entre la somme a de $MI_1$ et $GI_1$ et la somme b de $MI_2$ et $GI_2$ est toujours inférieure à une valeur prédéterminée δ, de même que a+ADJ1-b ou b+ADJ1-a. Si l'on choisit n tel que n≥2δ, le fait pour les additionneurs du module MM1 d'effectuer des additions modulo n n'introduit aucune erreur dans le calcul de la valeur produite en sortie par le module MM1. De la même façon, les valeurs de métriques d'état $MI_3$, $MI_4$ sont codées sur n bits et les additionneurs du module MM2 ainsi que l'additionneur 39 fonctionnent sans conservation de la retenue, d'où il résulte que la valeur produite en sortie du module MM1 est également codée sur n bits. Une telle structure de module ACSO présente l'avantage de ne jamais être saturée tout en étant particulièrement simple à mettre en oeuvre. En outre, une telle structure comporte de manière avantageuse un seul moyen (non représenté) de compensation de gain sur son entrée, et non une pluralité de tels moyens disposés au niveau des additionneurs réalisant les accumulations dans les modules ACSO classiques.

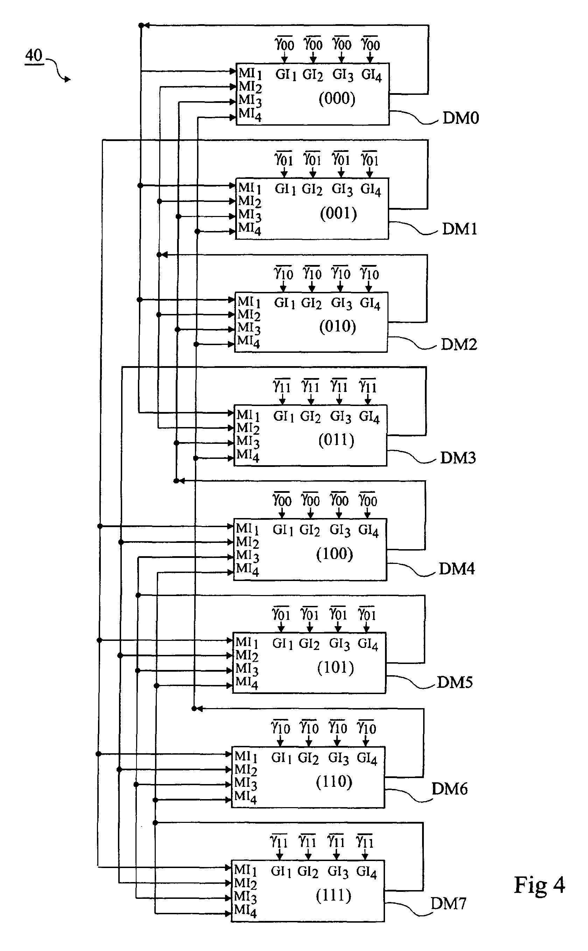

La figure 4 représente schématiquement un exemple de circuit 40 utilisant des modules ACSO en mode duobinaire selon l'invention pour effectuer un décodage basé sur le treillis de la figure 2. Le circuit 40 comporte huit modules ACSO (DM0, DM1, DM2, DM3, DM4, DM5, DM6, DM7). Les quatre entrées de métrique d'état $MI_1$, $MI_2$, $MI_3$, $MI_4$ des modules DM0, DM1, DM2 et DM3 sont respectivement reliées aux sorties des modules DM0, DM2, DM4 et DM6. Les quatre entrées de métrique d'état $MI_1$, $MI_2$, $MI_3$, $MI_4$ des modules DM4, DM5, DM6 et DM7 sont respectivement reliées aux sorties des modules DM1, DM3, DM5 et DM7. Les modules DM0, DM1, DM2, DM3, DM4, DM5, DM6, DM7 sont cadencés par un signal non représenté de manière à fournir une valeur de sortie à la réception de chaque bibit.

Les quatre entrées de métrique de branche $GI_1$, $GI_2$, $GI_3$, $GI_4$ des modules DM0 et DM4 sont reliées à un bloc non représenté fournissant à la réception de chaque bibit une métrique de branche $\bar{\gamma}_{00}$ correspondant à la distance entre la valeur 00 et la valeur du bibit reçu. De même, les entrées de métrique de branche des modules, respectivement DM1 et DM5, DM2 et DM6, DM3 et DM7 reçoivent à la réception de chaque bibit des valeurs $\bar{\gamma}_{01}$, $\bar{\gamma}_{10}$, $\bar{\gamma}_{11}$ correspondant aux distances entre les valeurs 01, 10, 11 et la valeur du bibit reçu.

Bien entendu, la présente invention est susceptible de diverses variantes et modifications qui apparaîtront à l'homme de l'art. En particulier, chacun des composants décrits pourra être remplacé par un ou plusieurs composants remplissant la même fonction. Ainsi, les structures du module MM1, du bloc de calcul 12 ou du bloc 15 pourront être semblables aux structures correspondantes décrites dans la demande de brevet européen numéro 03354009.7 déposée au nom de la demanderesse.

La présente invention a été décrite en relation avec un décodage selon un treillis à 8 états tel qu'en figure 2, mais l'homme du métier adaptera sans difficulté l'invention à un décodage selon d'autres treillis à 8 états ou selon un treillis à $2^N$ états, où N est supérieur à 1.

## Revendications

1. Dispositif (MM1) pour réaliser une fonction de type addition-comparaison-sélection-ajustement dans un décodeur de codes de correction d'erreur, comprenant :

   des premier et deuxième additionneurs (10, 11) pour produire des première et deuxième valeurs intermédiaires de métrique a et b respectivement égales à la somme d'une première métrique d'état précédent ($MI_1$) et d'une métrique de branche associée ($GI_1$) et à la somme d'une deuxième métrique d'état précédent ($MI_2$) et d'une métrique de branche associée ($GI_2$) ;
   un bloc de calcul (12) recevant les valeurs a et b, pour comparer les valeurs a et b, sélectionner la plus grande des valeurs a et b et fournir ladite valeur sélectionnée (MAX1) sur une première sortie, et pour produire sur une deuxième sortie une valeur d'ajustement (ADJ1) correspondant à une approximation de $\ln(1+e^{-|a-b|})$ ; et
   un troisième additionneur (19) pour produire une métrique d'état courant (MAXP1) égale à la somme des sorties (MAX1, ADJ1) du bloc de calcul (12) ;

   dans lequel les première et deuxième métriques d'état précédent ($MI_1$, $MI_2$) sont codées sur un même nombre de bits (n), et dans lequel les additionneurs (10, 11, 19) effectuent des additions sans conservation de la retenue de telle manière que la métrique d'état courant (MAXP1) et les valeurs intermédiaires a et b comportent le même nombre de bits (n) que les première et deuxième métriques d'état précédent ($MI_1$, $MI_2$).

2. Dispositif (DM) pour réaliser une fonction de type addition-comparaison-sélection-ajustement dans un décodeur de codes de correction d'erreur fonctionnant en mode duobinaire, comprenant :

   des premier (MM1) et second (MM2) dispositifs selon la revendication 1 comprenant respectivement des premier et deuxième blocs de calcul (12, 22) pour produire des première (MAXP1) et deuxième (MAXP2) métriques d'état courant respectivement à partir de première et deuxième métriques d'état précédent ($MI_1$, $MI_2$) et

de première et deuxième métriques de branches associées ($GI_1$, $GI_2$) et à partir de troisième et quatrième métriques d'état précédent ($MI_3$, $MI_4$) et de troisième et quatrième métriques de branche associées ($GI_3$, $GI_4$) ;
un troisième bloc de calcul (32) tel qu'en revendication 1 recevant en entrée les première (MAXP1) et deuxième (MAXP2) métriques d'état courant ; et
un additionneur (39) pour produire une troisième métrique d'état courant (MAXP1, MAXP2) égale à la somme des sorties (MAX3, ADJ3) du troisième bloc de calcul (32), dans lequel les métriques d'état précédent ($MI_1$, $MI_2$, $MI_3$, $MI_4$) sont codées chacune sur un même nombre (n) de bits, ledit additionneur (39) effectuant des additions sans conservation de la retenue de telle manière que la troisième métrique d'état courant (MAXP3) comporte le même nombre (n) de bits que les métriques d'état précédent ($MI_1$, $MI_2$, $MI_3$, $MI_4$).

3. Dispositif selon la revendication 1 ou 2, dans lequel le bloc de calcul (12, 22, 32) comporte :

un soustracteur (13, 23, 33) pour calculer la différence (a-b) des première (a) et deuxième (b) valeurs reçues par le bloc de calcul ;
un multiplexeur (14, 24, 34) commandé par la sortie du soustracteur pour produire sur la première sortie du bloc de calcul la plus grande des valeurs reçues (a,b) ;
un bloc d'approximation (15) pour produire sur la deuxième sortie du bloc de calcul (12) la valeur d'ajustement (ADJ1) sous la forme d'une valeur de un bit égale à 1 si ladite différence est égale à 0, 1 ou -1 et égale à 0 sinon.

4. Dispositif selon la revendication 3, dans lequel le bloc d'approximation (15) comporte une première porte logique (16) calculant un NON-OU de tous les bits de ladite différence (a-b) à l'exception de son bit de poids le plus faible, une deuxième porte logique (17) calculant un ET de tous les bits de ladite différence (a-b), et une troisième porte logique (18) calculant un OU des sorties des première et deuxième portes logiques (16, 17).

5. Décodeur comportant $2^N$, où N est supérieur à 1, dispositifs selon la revendication 2 (DM0, DM1, DM2, DM3, DM4, DM5, DM6, DM7) dont chacun est associé à une valeur de N bits particulière, le décodeur recevant des données sous forme de couples de bits ou bibits consécutifs ;
la sortie de chaque dispositif associé à une première valeur étant connectée de manière à fournir l'une des métriques d'état précédent à quatre dispositifs, associés chacun à une valeur dont les N-2 bits de poids fort sont les N-2 bits de poids faible de ladite première valeur et dont les deux bits de poids faibles sont respectivement l'une des quatre valeurs possibles du dernier bibit reçu ;
chaque dispositif associé à une première valeur dont les deux bits de poids faible sont l'une des quatre valeurs possibles (00, 01, 10, 11) d'un bibit recevant comme métriques de branche une valeur correspondant à une distance entre le bibit reçu et ladite une des quatre valeurs possibles d'un bibit.

6. Procédé pour réaliser une fonction de type addition-comparaison-sélection-ajustement dans un décodeur de codes de correction d'erreur fonctionnant en mode monobinaire, comprenant les étapes suivantes :

i/ produire des première et deuxième valeurs intermédiaires de métrique a et b respectivement égales à la somme d'une première métrique d'état précédent ($MI_1$) et d'une métrique de branche associée ($GI_1$) et à la somme d'une deuxième métrique d'état précédent ($MI_2$) et d'une métrique de branche associée ($GI_2$) ;
ii/ comparer les valeurs a et b, sélectionner la plus grande des valeurs a et b et fournir ladite valeur sélectionnée sur une première sortie, et produire sur une deuxième sortie une valeur d'ajustement correspondant à une approximation de $\ln(1+e^{-|a-b|})$ ; et
iii/ produire une métrique d'état courant égale à la somme des sorties du bloc de calcul ;

les première et deuxième métriques d'état précédent ($MI_1$, $MI_2$) étant codées sur un même nombre de bits et les sommes calculées aux étapes i/ et iii/ étant réalisées sans conservation de la retenue, de telle manière que la métrique d'état courant et les valeurs intermédiaires a et b comportent le même nombre de bits que les première et deuxième métriques d'état précédent ($MI_1$, $MI_2$).

7. Procédé pour réaliser une fonction de type addition-comparaison-sélection-ajustement dans un décodeur de codes de correction d'erreur fonctionnant en mode duobinaire, comprenant les étapes suivantes :

iv/ produire des première et deuxième métriques d'état courant selon le procédé de la revendication 6, respectivement à partir de première et deuxième métriques d'état précédent ($MI_1$, $MI_2$) et de première et deuxième métriques de branches associées ($GI_1$, $GI_2$) et à partir de troisième et quatrième métriques d'état précédent ($MI_3$, $MI_4$) et de troisième et quatrième métriques de branches associées ($GI_3$, $GI_4$) ;

v/ fournir une valeur sélectionnée et une valeur d'approximation calculées selon l'étape ii/ de la revendication 6 à partir des première et deuxième métriques d'état courant ; et

vi/ produire une troisième métrique d'état courant égale à la somme des valeurs produites à l'étape v/, les métriques d'état précédent ($MI_1$, $MI_2$, $MI_3$, $MI_4$) étant codées chacune sur un même nombre (n) de bits et ladite somme étant effectuée sans conservation de la retenue de telle manière que la troisième métrique d'état courant comporte le même nombre (n) de bits que les métriques d'état précédent ($MI_1$, $MI_2$, $MI_3$, $MI_4$).

8.  Procédé selon la revendication 6 ou 7, dans lequel à l'étape ii/, la valeur est sélectionnée en calculant la différence (a-b) des valeurs comparées (a, b) et en fournissant la plus grande des valeurs comparées (a,b) sur la base du signe de ladite différence (a-b), et dans lequel la valeur d'ajustement est produite comme étant une valeur de un bit égale à 1 si ladite différence est égale à 0, 1 ou -1 et égale à 0 sinon.

9.  Dispositif selon la revendication 8, dans lequel la valeur d'ajustement est égale au OU logique d'un NON-OU logique de tous les bits de ladite différence (a-b) à l'exception de son bit de poids le plus faible et d'un ET logique de tous les bits de ladite différence (a-b).

10. Décodage selon un treillis comportant $2^N$, où N est supérieur à 1, états associés chacun à une valeur de N bits particulière, de données reçues sous la forme de couples de bits ou bibits consécutifs, comportant les étapes suivantes :

vii/ pour le premier bibit reçu, produire selon le procédé de la revendication 7 $2^N$ métriques d'état courant associées chacune à l'une desdites valeurs à partir de quatre métrique d'état précédent initiales prédéterminées et à partir de quatre métriques de branche identiques correspondant à une distance entre le bibit reçu et une valeur du bibit égale aux deux bits de poids faible de ladite une desdites valeurs ;

viii/ pour chaque bibit reçu ultérieurement, produire selon le procédé de la revendication 7 $2^N$ métriques d'état courant associées chacune à l'une desdites valeurs en prenant pour les quatre métriques d'état précédent les quatre métriques d'état courant produites pour le bibit reçu précédent et associées à une valeur dont les N-2 bits de poids faible sont les N-2 bits de poids fort de ladite une desdites valeurs, et en prenant pour les quatre métriques de branche une distance entre le bibit reçu et une valeur du bibit égale aux deux bits de poids faible de ladite une desdites valeurs.

Fig 1

Fig 2

Fig 3

Fig 4

| | **Office européen** | **RAPPORT DE RECHERCHE EUROPEENNE** | Numéro de la demande |
| | **des brevets** | | EP 04 35 4020 |

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | US 2001/007142 A1 (DEFOSSEUX RAPHAEL ET AL) 5 juillet 2001 (2001-07-05) * alinéa [0050] - alinéa [0060]; figures 5,6 * ----- | 1-10 | H03M13/41 |
| A | EP 0 967 730 A (LUCENT TECHNOLOGIES INC) 29 décembre 1999 (1999-12-29) * alinéas [0010], [0011], [0033], [0034] * ----- | 1-10 | |

**DOMAINES TECHNIQUES RECHERCHES (Int.Cl.7)**

H03M

Le présent rapport a été établi pour toutes les revendications

| Lieu de la recherche | Date d'achèvement de la recherche | Examinateur |
|---|---|---|
| La Haye | 29 juillet 2004 | Devergranne, C |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
........................................................
& : membre de la même famille, document correspondant

EPO FORM 1503 03.82 (P04C02)

EP 1 475 895 A1

## ANNEXE AU RAPPORT DE RECHERCHE EUROPEENNE
## RELATIF A LA DEMANDE DE BREVET EUROPEEN NO.

EP 04 35 4020

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

29-07-2004

| Document brevet cité au rapport de recherche | Date de publication | Membre(s) de la famille de brevet(s) | Date de publication |
|---|---|---|---|
| US 2001007142 A1 | 05-07-2001 | US 6690750 B1<br>EP 1024604 A2 | 10-02-2004<br>02-08-2000 |
| EP 0967730 A | 29-12-1999 | US 2002010895 A1<br>EP 0967730 A1<br>JP 2000031836 A<br>JP 2003092536 A | 24-01-2002<br>29-12-1999<br>28-01-2000<br>28-03-2003 |

EPO FORM P0460

Pour tout renseignement concernant cette annexe : voir Journal Officiel de l'Office européen des brevets, No.12/82

17